# DEMANDE DE BREVET EUROPEEN

(11) **EP 1 909 388 A1**
(43) Date de publication de la demande: **09.04.2008**
(21) Numéro de dépôt: 07117607.7
(22) Date de dépôt: 01.10.2007
(51) Int. Cl.: H03H 1/00, H02M 1/44, H01F 17/06

(54) **Dispositif de filtrage de mode commun et variateur de vitesse comportant un tel dispositif**

(30) Priorité: 06.10.2006 FR 0654133
(71) Demandeur: Schneider Toshiba Inverter Europe SAS, 27120 Pacy sur Eure (FR)
(72) Inventeur: Lafontaine, Jean, 78600, MAISONS LAFFITTE (FR)
(74) Mandataire: Dufresne, Thierry

(57) **Abrégé**

L'invention concerne un dispositif de filtrage qui comprend une inductance de mode commun (L_{F}) comportant un enroulement (L1,L2) sur chaque ligne d'un réseau d'alimentation alternatif et un noyau magnétique composé d'un premier tore (T1) et d'un second tore (T2). Le premier tore (T1) est doté d'une première perméabilité magnétique (µ1) et le second tore (T2) est doté d'une seconde perméabilité magnétique (µ2,µ'2), la première perméabilité étant supérieure ou égale au triple de la seconde perméabilité, pour éviter la saturation de l'inductance de mode commun dans la zone de fréquence de résonance du dispositif de filtrage. Application au filtre CEM d'un variateur de vitesse.

## Description

La présente invention se rapporte à un dispositif de filtrage de mode commun, tel qu'un filtre CEM (Compatibilité Electro-Magnétique) utilisé en entrée d'un variateur de vitesse de type convertisseur de fréquence qui est alimenté par un réseau d'alimentation alternatif et qui est destiné à la commande d'un moteur électrique synchrone ou asynchrone. L'invention concerne également un variateur de vitesse comprenant un tel dispositif de filtrage.

De façon connue, un variateur de vitesse du type convertisseur de fréquence comporte un module redresseur qui fournit une tension continue à partir d'un réseau d'alimentation alternatif extérieur. Le variateur de vitesse comporte ensuite un module onduleur (ou hacheur) doté de composants électroniques semi-conducteurs de puissance pour hacher la tension continue en Modulation de Largeur d'Impulsion (MLI ou Pulse Width Modulation - PWM), de façon à fournir en sortie via un câble puissance une tension électrique variable pulsée et une fréquence de rotation variable au moteur. Un dispositif de commande du variateur contrôle la conduction et le blocage des composants semi-conducteurs à la fréquence d'échantillonnage, pour commander le moteur en MLI avec une tension variable appropriée.

La fréquence de commutation pour la commande MLI des semi-conducteurs de puissance correspond à la fréquence d'échantillonnage du variateur. En fonction du type et du calibre du variateur, cette fréquence de commutation varie généralement entre approximativement 2 et 16 kHz.

La commutation des semi-conducteurs de puissance génère en sortie du variateur de vitesse une variation de la tension de mode commun entraînant en amont et en aval du système de conversion des perturbations électromagnétiques de même mode, au travers d'un bouclage par la terre des courants de fuite dus notamment aux capacités parasites du moteur et du câble puissance. Un dispositif de filtrage est donc souvent utilisé pour atténuer les courants de mode commun absorbés au réseau de distribution électrique et éviter leur propagation vers le réseau d'alimentation.

Un filtre CEM est placé en amont du module redresseur du variateur de vitesse et est connecté entre le réseau d'alimentation alternatif et le module redresseur du variateur. Suivant l'encombrement du filtre et suivant la taille et le type du variateur, le filtre peut être soit intégré dans le boîtier du variateur, soit externe au variateur. Pour répondre notamment aux normes européennes actuelles en matière de compatibilité électromagnétique, le filtre CEM doit être efficace dans une zone de fréquence située entre 150 kHz à 30 MHz.

Le filtre CEM comporte habituellement une inductance de mode commun comprenant un enroulement sur chaque ligne conductrice du réseau d'alimentation, et des condensateurs de mode commun reliés entre chaque ligne et la terre, en aval de l'inductance de mode commun. Le filtre forme ainsi un circuit passif de type passe-bas avec une fréquence de coupure permettant d'obtenir l'atténuation désirée des courants de mode commun dans la zone de fréquence fixée par les normes.

La zone de fréquence de coupure souhaitée du filtre CEM fixe les valeurs des condensateurs et de l'inductance de mode commun. La valeur des condensateurs de mode commun est en générale constante. Par contre, la valeur de l'inductance de mode commun dépend fortement des courants de mode commun qui la traverse. Ces courants sont fonctions de la tension de mode commun générée par la commutation des interrupteurs du variateur de vitesse et des capacités parasites des principaux éléments que sont le moteur et le câble puissance. En fonction du niveau accepté des courants de mode commun, l'inductance de mode commun doit donc être largement dimensionnée afin de ne pas saturer.

Le filtre CEM étant un circuit passif du deuxième ordre, il comporte une fréquence de résonance proche de sa fréquence de coupure. Ainsi, il se peut que, dans une certaine bande de fréquence autour de la fréquence de résonance, le filtre CEM amplifie les courants de mode commun au lieu de les atténuer, favorisant ainsi la saturation de l'inductance.

La valeur de cette fréquence de résonance dépend évidemment de la valeur de l'inductance de mode commun, laquelle dépend de la valeur du courant de mode commun. Donc, la fréquence de résonance varie aussi suivant que le variateur de vitesse entraîne ou non une charge. Ainsi, la fréquence de résonance peut être par exemple de l'ordre de 8 à 16 kHz pour une inductance du filtre CEM en ferrite, et par exemple de l'ordre de 2 à 8 kHz pour une inductance en matériau nano-cristallin. Il se trouve que ces valeurs sont proches des valeurs de fréquences d'échantillonnage habituelles d'un variateur.

Pour une meilleure efficacité du filtrage, il est donc souhaitable de mettre en place un dispositif de filtrage comportant des moyens permettant d'éviter de manière très simple et économique la saturation de l'inductance de mode commun du filtre CEM dans une zone de fréquence située au voisinage de la fréquence de résonance du filtre CEM (c'est-à-dire aux alentours de 1 à 16 kHz), sans pour autant pénaliser les performances du filtre CEM dans la zone de fréquence normative de filtrage, au-delà de 150 kHz.

La demande de brevet FR 06 52040 décrit déjà une solution qui préconise l'utilisation d'un circuit de dérivation adapté. Cette solution est économiquement avantageuse surtout pour des variateurs de petite puissance, par exemple inférieurs à 5 kW. Pour des variateurs de forte puissance, il est aussi possible de mettre des filtres à deux étages (dimension 4), mais cette solution est encombrante et coûteuse. L'invention a donc pour but de proposer une solution adaptée aux variateurs de plus forte puissance et basée sur un dispositif de filtrage à un seul étage (dimension 2 ou 2^{ème} ordre).

C'est pourquoi, l'invention décrit un dispositif de filtrage raccordé à un réseau d'alimentation alternatif, le dispositif de filtrage comprenant une inductance de mode commun comportant un enroulement sur chaque ligne du réseau d'alimentation et un noyau magnétique composé d'un premier tore et d'un second tore. Le premier tore est réalisé avec un premier matériau doté d'une première perméabilité magnétique et le second tore est réalisé avec un second matériau doté d'une seconde perméabilité magnétique. La valeur de l'induction de saturation du premier matériau est supérieure ou sensiblement égale à la valeur de l'induction de saturation du second matériau. De plus, la valeur de la première perméabilité magnétique est supérieure ou égale au triple de la valeur de la seconde perméabilité magnétique à une fréquence de 10 kHz d'un courant traversant les enroulements, pour éviter la saturation de l'inductance de mode commun dans la zone de fréquence de résonance du dispositif de filtrage.

Selon une caractéristique, le premier matériau et le second matériau sont des matériaux nano-cristallins de structure différente. Selon une autre caractéristique, le premier matériau est un matériau nano-cristallin et le second matériau est un matériau en ferrite. Un matériau en ferrite présente l'avantage d'être moins cher mais un matériau nano-cristallin offre une meilleure tenue en température.

Grâce à l'invention, on pourra ainsi avantageusement diminuer fortement la taille du filtre CEM d'un variateur de vitesse tout en conservant ses performances de filtrage à 150 kHz et au-delà, et donc réduire le coût du filtre et du variateur. En supprimant la saturation de l'inductance de mode commun du filtre CEM dans la zone de fréquence de résonance du filtre CEM (aux alentours de quelques kHz), il devient également possible de régler la fréquence d'échantillonnage du variateur de façon continue sur toute la plage de fonctionnement (généralement entre approximativement 2 et 16 kHz) sans nuire aux performances du filtre CEM. L'invention permettra aussi de réduire l'échauffement du filtre CEM et de diminuer les selfs de fuite, en raison d'un nombre de spires moins important. De plus, suivant la valeur des condensateurs de mode commun du filtre CEM, on pourra également autoriser une augmentation sensible de la longueur des câbles puissance entre variateur et moteur.

D'autres caractéristiques et avantages vont apparaître dans la description détaillée qui suit en se référant à un mode de réalisation donné à titre d'exemple et représenté par les dessins annexés sur lesquels :
- la figure 1 montre un schéma de principe simplifié connu d'un variateur de vitesse,
- les figures 2 et 3 détaillent des exemples de réalisation d'une inductance de mode commun du dispositif de filtrage conforme à l'invention,
- la figure 4 représente un diagramme de l'induction magnétique d'une inductance en fonction des ampères tours, pour une fréquence de l'ordre de 10 kHz,
- la figure 5 représente un diagramme de la perméabilité magnétique relative de différents matériaux en fonction de la fréquence.

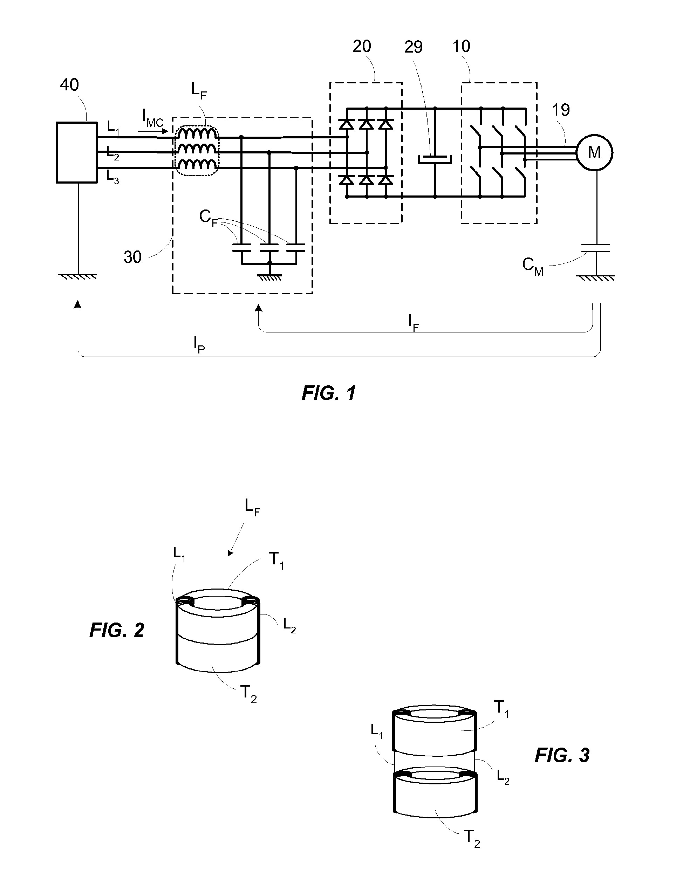

En référence au schéma de principe simplifié de la figure 1, un variateur de vitesse est destiné à la commande d'un moteur électrique M de type synchrone ou asynchrone. Le variateur comprend un module onduleur 10 relié au moteur M par un câble de puissance 19. Pour chaque phase du moteur, le module onduleur 10 comprend deux composants électroniques semi-conducteurs de puissance de type IGBT ou autres (représentés sur la figure 1 comme de simples interrupteurs pour simplifier le dessin), capables de fournir une tension pulsée en MLI au moteur M à partir d'un bus continu de tension.

En amont du module onduleur 10, le variateur comporte également un module redresseur 20 qui délivre le bus continu de tension pour alimenter le module onduleur 10. Un condensateur de ballast 29 est placé entre le module redresseur 20 et le module onduleur 10.

Le module redresseur 20 est alimenté par une source d'alimentation extérieure 40 fournissant une tension alternative triphasée L1,L2,L3, par un exemple dans un réseau de type TT où le neutre est relié à la terre. De façon classique, le module redresseur 20 comprend des ponts de diodes positionnés de façon à fournir le bus continu de tension. La figure 1 montre un réseau d'alimentation extérieur triphasé, mais l'invention s'applique de façon équivalente à un réseau d'alimentation monophasé. De même, le moteur M décrit dans la figure 1 est alimenté en triphasé mais l'invention s'applique évidemment aussi à un moteur électrique alimenté en monophasé.

Un dispositif de filtrage 30, composé d'un filtre CEM, est positionné entre la source d'alimentation 40 et le module redresseur 20. Les caractéristiques de ce filtre CEM sont calculées pour permettre au variateur de vitesse de répondre aux normes CEM dans une zone de fréquence au-delà de 150 kHz. Le filtre CEM 30 comporte une inductance de mode commun L_{F} connectée en série entre la source 40 et le module redresseur 20. Elle est composée d'un enroulement sur chaque ligne L1,L2,L3 du réseau d'alimentation, les enroulements étant magnétiquement couplés entre eux. Le filtre CEM 30 comporte également des condensateurs de mode commun C_{F} connectés entre chaque ligne L1,L2,L3 et la terre, en aval de l'inductance de mode commun L_{F}. Le filtre CEM 30 peut en plus comporter des capacités différentielles entre phases (filtrage différentiel) non représentées sur la figure 1. Suivant l'encombrement du filtre et suivant le calibre et le type du variateur, le filtre CEM 30 peut être soit intégré dans le boîtier du variateur, soit externe au variateur.

On sait que le moteur M et le câble 19 ont des capacités parasites réparties à la terre, que l'on peut modéliser par une capacité commune C_{M}. La commutation des semi-conducteurs du module onduleur 10 entraîne des variations de tension très importantes qui provoquent la création d'un courant de mode commun I_{MC} égal à I_{MC} = C_{M} * dV/dt.

Ce courant de mode commun I_{MC} se reboucle par la terre via la capacité moteur+câble C_{M} en empruntant soit un chemin noté I_{F} dans la figure 1, via le module redresseur 20, le module onduleur 10, C_{M}, C_{F}, soit un chemin noté I_{P} via le module redresseur 20, le module onduleur 10, C_{M}, 40, L_{F}. Pour minimiser la propagation des perturbations sur le réseau extérieur, on souhaite évidemment privilégier le chemin I_{F} plutôt que le chemin I_{P} pour éviter de propager les perturbations sur le réseau électrique extérieur. Dans ce but, on utilise donc des valeurs d'impédances faibles pour les condensateurs de mode commun C_{F1},C_{F2},C_{F3} et des valeurs d'impédances fortes pour l'inductance de mode commun L_{F}.

Néanmoins, plus le câble 19 est long, plus la capacité C_{M} augmente et plus le courant de mode commun I_{Mc} augmente. Dans certaines applications, il y a alors risque de saturation de l'inductance de mode commun L_{F} qui ne va plus filtrer le courant I_{Mc}. Dans ce cas, le chemin I_{F} risque de ne plus être privilégié ce qui va nuire aux performances du filtre CEM. Ce risque de saturation peut être accentué au moment des commutations des semi-conducteurs du module onduleur 10, c'est à dire à une fréquence de commutation pour la commande MLI des semi-conducteurs de puissance. Cette fréquence de commutation correspond à la fréquence d'échantillonnage du variateur, c'est-à-dire généralement entre approximativement 2 et 16 kHz.

Ainsi, à cette fréquence d'échantillonnage, on risque de voir apparaître côté réseau d'alimentation des pics de courant dus à la saturation de l'inductance de mode commun L_{F} lorsque le courant de mode commun I_{Mc}, généré par les commutations des semi-conducteurs du module onduleur 10, est important et amplifié par la résonance du filtre CEM d'entrée. Il faut donc trouver des moyens pour supprimer la résonance du filtre CEM et limiter ainsi la hausse du courant de mode commun I_{MC} circulant dans l'inductance de mode commun L_{F}.

Un des buts de l'invention est donc de proposer un système capable d'éviter la saturation de l'inductance de mode commun L_{F} dans la zone de fréquence de résonance du filtre CEM, sans dégrader les performances du filtre CEM dans la zone de fréquence au-delà de 150 kHz, pour répondre aux normes CEM.

En référence à la figure 2, l'inductance de mode commun L_{F} comporte un enroulement L1,L2 sur chaque ligne d'un réseau d'alimentation et un noyau magnétique composé d'un premier tore T1 et d'un second tore T2. Dans cet exemple et pour des commodités de dessin, le réseau d'alimentation ne comprend que deux lignes d'alimentation L1,L2 seulement (réseau monophasé).

Le premier tore T1 est juxtaposé au second tore T2 et les lignes d'alimentation sont simultanément enroulées autour des deux tores d'un nombre de spires égal à n. Selon l'invention, le premier tore T1 est réalisé avec un premier matériau doté d'une première perméabilité magnétique µ1 et le second tore T2 est réalisé avec un second matériau doté d'une seconde perméabilité magnétique µ2. La valeur de µ1 est supérieure ou égale au triple de la valeur de la seconde perméabilité magnétique µ2. Le but est d'avoir un grand écart entre les deux valeurs de perméabilité magnétique, pour profiter au mieux des qualités distinctes de chaque matériau et permettre d'obtenir l'effet recherché.

La notion de "perméabilité magnétique" utilisée dans l'ensemble du présent document représente en fait la perméabilité magnétique relative d'un matériau par rapport à la perméabilité du vide. Par souci de cohérence et sauf indication contraire, cette perméabilité magnétique relative est une perméabilité magnétique initiale, c'est-à-dire mesurée pour un courant traversant les enroulements de l'inductance de mode commun de valeur faible et ayant une fréquence de 10 kHz.

La figure 3 montre une variante de la figure 2. Dans ce cas, l'inductance de mode commun L_{F} comporte deux tores T1 et T2 qui ne sont pas juxtaposés mais séparés et les lignes d'alimentation L1,L2 traversent d'abord le premier tore T1 avec un premier nombre de spires n1 puis le second tore T2 avec un second nombre de spires n2. Cette variante est équivalente à l'exemple de la figure 2, si n1 et n2 sont égaux à n. Elle nécessite néanmoins deux séries d'enroulements.

Différentes structures sont possibles pour l'inductance de mode commun L_{F}. Par exemple, l'inductance L_{F} peut comporter indifféremment des tores T1 et T2 de mêmes dimensions (voir figures 2 & 3) ou de formes et de dimensions différentes. Un des tores pourrait par exemple être inséré dans l'espace intérieur de l'autre tore. De même, dans le cas de la figure 3, les nombres de spires n1 et n2 peuvent être égaux ou différents, en fonction des caractéristiques souhaitées du filtre CEM. Par ailleurs, les lignes d'alimentation L1,L2 pourraient aussi traverser d'abord le tore T2, puis le tore T1.

Le premier matériau est par exemple un matériau nano-cristallin dont le diamètre des grains est de l'ordre de 10 à 20 nm ou moins, de façon à obtenir une première perméabilité magnétique µ1 supérieure ou égale à 50000. Préférentiellement, on choisira un premier matériau dont la perméabilité magnétique µ1 sera de l'ordre de 60000 à 100000 et avec une induction de saturation de l'ordre de 1,2 à 1,5 Tesla.

Le second matériau doit posséder une perméabilité magnétique inférieure au tiers de la perméabilité magnétique du premier matériau. Ce second matériau peut notamment être une ferrite, qui présente l'avantage d'être peu coûteux et possède une perméabilité magnétique µ2 par exemple de l'ordre de 8000 à 10000 avec une induction de saturation de l'ordre de 0,5 Tesla.

Le second matériau pourrait également être un matériau nano-cristallin de structure et/ou de composition différentes par rapport au premier matériau, de façon à obtenir une perméabilité magnétique µ'2 inférieure ou égale à 30000. Préférentiellement, on choisira un second matériau dont la perméabilité magnétique µ'2 sera de l'ordre de 10000 à 20000 avec une induction de saturation de l'ordre de 1,2 à 1,5 Tesla.

Ainsi, le rapport entre les perméabilités magnétiques µ1 et µ2 (ou µ'2) sera préférentiellement supérieur ou égal à quatre, par exemple µ1 de l'ordre de 100000 et µ2 (ou µ'2) de l'ordre de 20000, ou µ1 de l'ordre de 60000 et µ2 (ou µ'2) de l'ordre de 10000.

Par ailleurs, la ferrite est moins coûteuse que le nano-cristallin mais présente le désavantage de perdre ses caractéristiques à haute température, typiquement au-dessus du point de Curie généralement proche de 100°C, et donc de filtrer moins efficacement, ce qui n'est pas le cas du nano-cristallin. Le mode de réalisation consistant à utiliser deux matériaux nano-cristallins avec des perméabilités magnétiques différentes µ1, µ'2 pour le premier tore et le second tore permet ainsi d'avoir des performances de filtrage acceptables jusqu'à des températures de l'ordre de 150°C.

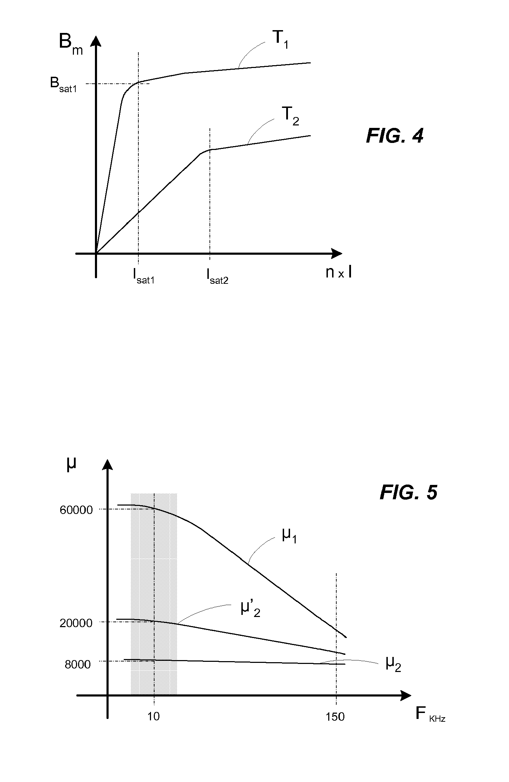

La figure 4 montre, pour différents matériaux magnétiques du noyau d'une inductance, différentes courbes donnant la valeur de l'induction magnétique B en fonction des ampères tours n*I traversant l'inductance (enroulement de n spires traversées par un courant I) à une fréquence de l'ordre de 10 kHz. La figure 5 montre différents exemples de valeurs de perméabilité magnétique en fonction de la fréquence. On remarque qu'une forte perméabilité magnétique µ1 à une fréquence de 10 kHz chute fortement lorsque la fréquence augmente entre 10 kHz et 150 kHz, contrairement à une perméabilité magnétique plus faible µ2. Dans la figure 5, la zone grisée symbolise approximativement la zone de voisinage de la fréquence de résonance.

La figure 4 montre que l'induction de saturation Bₛₐₜ₁ du premier matériau est supérieure à de saturation du second matériau. Le second tore T2 a une faible perméabilité magnétique µ2, ce qui fait que la valeur de l'induction magnétique monte assez lentement à mesure que le courant augmente (voir figure 4). Pour atteindre le courant de saturation Iₛₐₜ₂, il faut donc une valeur importante d'ampères tours n*I. Au contraire, le premier tore T1 ayant une forte perméabilité magnétique µ1, la valeur de l'induction magnétique monte très rapidement avec le courant et le courant de saturation Iₛₐₜ₁ correspondant à une induction de saturation Bₛₐₜ₁ est très vite atteint.

Ainsi, une inductance L_{F} dont le noyau n'est composé que d'un matériau à forte perméabilité magnétique µ1 possède l'avantage d'avoir une forte valeur d'inductance à basse fréquence et donc de fournir un filtrage de mode commun efficace, mais possède le désavantage de saturer rapidement avec peu de courant circulant dans l'inductance. En effet, la valeur de l'inductance est proportionnelle à la perméabilité magnétique µ du matériau du noyau de l'inductance, alors que le courant de saturation Iₛₐₜ est inversement proportionnel à cette perméabilité magnétique p.

Inversement, une inductance L_{F} dont le noyau n'est composé que d'un matériau à faible perméabilité magnétique µ2 possède l'avantage de supporter plus d'ampères tours avant de saturer, mais possède le désavantage d'avoir une valeur d'inductance plus faible à basse fréquence et donc de fournir un filtrage de mode commun moins efficace.

L'invention associe donc ces deux matériaux différents en série dans une inductance de mode commun L_{F} de façon à bénéficier des avantages de chacun en additionnant les effets des deux technologies.

Le fonctionnement d'une telle inductance de mode commun est le suivant :

Au départ, à basse fréquence au-dessous de la fréquence d'échantillonnage du variateur, on cumule les effets de T1 et T2 pour filtrer le courant de mode commun I_{Mc} correspondant. En particulier, le filtrage obtenu par T1+T2 est beaucoup plus efficace que si l'on avait qu'un seul tore T2 de taille équivalente ayant une perméabilité magnétique faible.

Au fur et à mesure que la fréquence et le courant de mode commun I_{Mc} correspondant augmentent, les ampères tours augmentent et on va rapidement atteindre le seuil théorique de saturation Iₛₐₜ₁ du tore T1, car sa perméabilité magnétique µ1 est élevée. Donc si T1 était seul, le courant de mode commun I_{MC} devrait alors augmenter très rapidement. Mais, grâce à sa faible perméabilité magnétique µ2 (ou µ'2), le tore T2 n'est pas saturé, et donc le courant de mode commun I_{MC} va être limité de façon à rester proche de la valeur de saturation Iₛₐₜ₁, dans le coude de saturation de la courbe T1 de la figure 4 (c'est-à-dire un fonctionnement en quasi-saturation de T1).

Dans le cas où le tore T1 est saturé à basse fréquence et que le tore T2 ne l'est pas, alors, lorsque la fréquence du courant de mode commun continue à augmenter, la perméabilité µ1 de T1 va diminuer, comme indiqué en figure 5, ce qui va avoir pour conséquence de faire augmenter avantageusement son seuil de saturation Iₛₐₗ₁. Ainsi, grâce à la présence de T2 qui a permis de rester dans le coude de saturation du tore T1, on va pouvoir à partir d'une certaine fréquence revenir au dessous du seuil de saturation Iₛₐₗ₁ jusqu'à la fréquence de 150 kHz, à condition de calculer les caractéristiques du filtre CEM de façon à repousser la fréquence de résonance du filtre CEM hors de la zone de fréquence d'échantillonnage du variateur.

Si le courant de mode commun I_{MC} reste au-dessous du seuil de saturation Iₛₐₜ₁, la saturation du tore T1 pourrait être néanmoins due à la résonance du filtre CEM née de l'excitation des harmoniques de courant de mode commun générés à la fréquence d'échantillonnage du variateur. Dans ce cas, la saturation du tore T1 modifie avantageusement la valeur de l'inductance de mode commun qui ne comporte plus que le tore T2, ce qui entraîne une modification de la fréquence de résonance du filtre CEM et donc la suppression de sa résonance.

Ainsi, lorsqu'un filtre CEM d'un variateur utilise une inductance de mode commun classique, la longueur du câble puissance est limitée à quelques mètres car la saturation de l'inductance est rapidement atteinte quelle que soit la nature du matériau magnétique utilisé. En effet, si le matériau magnétique a une faible perméabilité, la saturation est due à une faible limitation du courant de mode commun. Si le matériau magnétique a une forte perméabilité, la saturation est due à l'induction magnétique qui monte très rapidement avec le courant de mode commun.

En utilisant une inductance de mode commun L_{F} comportant deux tores avec des perméabilités magnétiques très différentes conformément à l'invention, on bénéficie à la fois d'un courant de mode commun fortement limité (effet du tore T1) et d'un matériau magnétique dont l'induction monte lentement (effet du tore T2). Il est alors possible d'éviter la saturation de cette inductance et donc d'assurer un très bon filtrage du courant de mode commun sur toute la plage de fréquence.

Il est bien entendu que l'on peut, sans sortir du cadre de l'invention, imaginer d'autres variantes et perfectionnements de détail et de même envisager l'emploi de moyens équivalents.

## Revendications

1. Dispositif de filtrage raccordé à un réseau d'alimentation alternatif, qui comprend une inductance de mode commun (L_{F}) comportant un enroulement (L1, L2) sur chaque ligne du réseau d'alimentation et un noyau magnétique composé d'un premier tore (T1) et d'un second tore (T2), **caractérisé en ce que** :
- le premier tore (T1) est réalisé avec un premier matériau nano-cristallin doté d'une première perméabilité magnétique (µ1) et le second tore (T2) est réalisé avec un second matériau doté d'une seconde perméabilité magnétique (µ2),
- la valeur de l'induction de saturation (Bₛₐₜ₁) du premier matériau est supérieure ou sensiblement égale à la valeur de l'induction de saturation du second matériau,
- la valeur de la première perméabilité magnétique (µ1) est supérieure ou égale au triple de la valeur de la seconde perméabilité magnétique (µ2) à une fréquence de 10 kHz d'un courant traversant les enroulements, pour éviter la saturation de l'inductance de mode commun (L_{F}) dans la zone de fréquence de résonance du dispositif de filtrage (30).

2. Dispositif de filtrage selon la revendication 1, **caractérisé en ce que** la valeur de la première perméabilité magnétique (µ1) est supérieure ou égale à 50000 à une fréquence de 10 kHz du courant traversant les enroulements.

3. Dispositif de filtrage selon la revendication 1, **caractérisé en ce que** la valeur de la seconde perméabilité magnétique (µ2, µ'2) est inférieure ou égale à 30000 à une fréquence de 10 kHz du courant traversant les enroulements.

4. Dispositif de filtrage selon la revendication 1, **caractérisé en ce que** le premier matériau et le second matériau sont des matériaux nano-cristallins de structure différente.

5. Dispositif de filtrage selon la revendication 1, **caractérisé en ce que** le second matériau est un matériau en ferrite.

6. Dispositif de filtrage selon la revendication 1, **caractérisé en ce que** le premier tore (T1) est juxtaposé au second tore (T2), et **en ce que** chaque enroulement de ligne (L1, L2) traverse simultanément le premier tore (T1) et le second tore (T2).

7. Dispositif de filtrage selon la revendication 1, **caractérisé en ce que** chaque enroulement de ligne (L1, L2) traverse le premier tore (T1) d'un premier nombre de spires puis traverse le second tore (T2) d'un second nombre de spires.

8. Variateur de vitesse comprenant un module redresseur (20) alimenté par un réseau d'alimentation alternatif (L1,L2,L3), **caractérisé en ce qu'**il comporte un dispositif de filtrage (30) selon l'une des revendications précédentes, connecté entre le réseau d'alimentation et le module redresseur.
